# EUROPÄISCHE PATENTSCHRIFT

(11) **EP 1 395 098 B1**
(45) Veröffentlichungstag und Bekanntmachung des Hinweises auf die Patenterteilung: **26.08.2009**
(21) Anmeldenummer: 02019707.5
(22) Anmeldetag: 02.09.2002
(51) Int. Cl.: H05K 1/02, B60H 1/22, H01L 23/367

(54) **Elektrische Heizung für Kraftfahrzeuge**
Electrical heating for vehicle
Chauffage électrique pour véhicule

(43) Veröffentlichungstag der Anmeldung: 03.03.2004
(73) Patentinhaber: Eberspächer catem GmbH & Co. KG, 76863 Herxheim bei Landau (DE)
(72) Erfinder: Uhl, Günter Dr., 74921 Helmstadt-Bargen (DE); Niederer, Michael, 76889 Kapellen-Drusweiler (DE); Bernhardt, Marc, 67204 Achenheim (FR); Bohlender, Franz, 76870 Kandel (DE)
(74) Vertreter: Grünecker, Kinkeldey, Stockmair & Schwanhäusser Anwaltssozietät

(56) Entgegenhaltungen:
- EP-A- 0 901 311
- EP-A- 0 907 307
- EP-A- 1 157 867
- WO-A-00/54560
- DE-A- 4 220 966
- DE-A- 19 949 429
- FR-A- 2 639 764
- FR-A- 2 777 734
- GB-A- 2 345 576
- US-A1- 2001 050 843
- US-A1- 2002 011 484
- PATENT ABSTRACTS OF JAPAN vol. 009, no. 251 (E-348), 8. Oktober 1985 (1985-10-08) & JP 60 100457 A (MATSUSHITA DENKI SANGYO KK), 4. Juni 1985 (1985-06-04)

## Beschreibung

Die Erfindung bezieht sich auf eine elektrische Heizvorrichtung zur Lufterwärmung, die sich insbesondere für den Einsatz als elektrische Zusatzheizung in Kraftfahrzeugen eignet.

Für den Einsatz in Kraftfahrzeugen, insbesondere solchen mit verbrauchsoptimierten Motoren, werden elektrische Heizvorrichtungen zur Beheizung des Innenraums und/oder des Motors verwendet. Eine elektrische Zusatzheizung ist insbesondere nach dem Starten des Motors erforderlich, solange der Verbrennungsmotor noch keine ausreichende Wärmeenergie zur Verfügung stellt. Verbrauchsoptimierte Verbrennungsmotoren erfordern sogar grundsätzlich den Einsatz elektrischer Zusatzheizen.

Der Einsatz solcher Heizvorrichtungen ist jedoch nicht auf den Kraftfahrzeugbereich beschränkt, sie sind auch für eine Vielzahl anderer Einsatzzwecke geeignet, beispielsweise im Bereich von Hausinstallationen (Raumklimatisierung), Industrieanlagen u.dgl.

Aus EP-A2-0 901 311 ist eine elektrische Heizvorrichtung für Kraftfahrzeuge bekannt. Die beschriebene Heizvorrichtung umfasst mehrere zu einem Heizblock zusammengesetzte Heizelemente. Der Heizblock wird zusammen mit einer Steuervorrichtung zur Ansteuerung der Heizelemente in einem gemeinsamen Rahmen gehalten. Die Steuervorrichtung bildet so mit dem in dem Rahmen gehaltenen Heizblock eine bauliche Einheit. Die Steuervorrichtung umfasst eine Leistungselektronik mit elektronischen Schaltern, die jeweils mit einem Kühlkörper versehen sind. Die Steuervorrichtung ist so angeordnet, dass ein Teil des zu erwärmenden Luftstroms die Steuervorrichtung, insbesondere die Kühlelemente, zur Kühlung der elektronischen Schalter anströmt.

Die elektronischen Schalter, insbesondere in Form von Leistungstransistoren, die den Strom steuern, der den Heizelementen zugeführt wird, sind mit einer Seite direkt auf einer Leiterplatte montiert. Zur Abführung der von den Leistungstransistoren erzeugten Verlustwärme ist auf der gegenüberliegenden Seite der Leiterplatte ein Kühlelement oder -blech vorgesehen. Um den Wärmeübergang zwischen Transistor und Kühlelement durch die Leiterplatte hindurch zu verbessern, ist die Leiterplatte im Bereich zwischen dem Transistor und dem Kühlelement mit einer Vielzahl von Durchkontaktierungen versehen. Nachteilig an dieser bekannten Vorgehensweise ist, dass die Wärmeleitfähigkeit dieser Durchkontaktierungen nicht ausreicht, um die Verlustwärme abzuleiten. Obwohl diese Durchkontaktierungen in einem Bereich von in etwa 1 cm² unter dem Leistungstransistor vorgesehen sind, kann mit ihnen die Verlustwärme in einer Größenordnung von über/mehr als 6 Watt nicht zu den Kühlelementen geleitet werden.

Aus EP-A- 1157 867 ist eine elektrische Heizvorrichtung bekannt, bei der ebenfalls das Heizregister und die elektrische Steuervorrichtung in einer baulichen Einheit integriert sind. Die Leistungstransistoren der Steuereinheit sind direkt auf der Leiterplatte angeordnet und werden auf ihrer Unterseite über eine in der Leiterplatte vorgesehene Bohrung von einem Kühlelement kontaktiert. Ein solches Kühlelement, das direkt den Leistungstransistor kontaktiert, kann die Verlustwärme des Leistungstransistors auf einfache Weise und in ausreichender Menge abführen.

Nachteilig an dieser Heizvorrichtung ist jedoch die Klemmbefestigung des Kühlelementes an dem Transistor. Fahrzeugvibrationen können sich negativ auf die Befestigung des Kühlelementes auswirken, so dass eine effektive Wärmeübertragung vermindert wird. Zudem ist die Klemmung nicht in der Lage, Unebenheiten in der Anlagefläche von Transistor und der Oberfläche des durch die Leiterplatte ragenden Zapfenelementes auszugleichen. Dadurch wird der Wärmeübergang unkalkulierbar beeinträchtigt, und die Anlagefläche ist nicht in der Lage, die Verlustwärme vom Leistungstransistor über der gesamten Transistorfläche gleichmäßig abzuleiten.

Alternativ können der Transistor und das Kühlelement an der Anlagefläche miteinander verlötet werden. Mit dieser Befestigung kann die Klemmung entfallen und gleichzeitig kann ein zuverlässig hoher Wärmeübergangswert an der Anlagefläche von Transistor und der Oberfläche des durch die Leiterplatte ragenden Zapfens des Kühlelements sichergestellt werden. Nachteilig an einer solchen Befestigung ist die aufwändige Herstellung. Die Leistungstransistoren sind wegen ihrer im Vergleich zu den Kühlkörpem sehr viel geringeren Masse einer besonders hohen thermischen Belastung bei einem solchen Herstellungsvorgang ausgesetzt. Die hohe Masse des Kühlkörpers erfordert, dass die Steuerschaltung während des Lötvorgangs über einen sehr viel längeren Zeitraum als herkömmlich auf der Löttemperatur gehalten werden muss, um auch den ganzen Kühlkörper auf die entsprechende Temperatur aufzuheizen. Beim Lötvorgang wird die Steuerschaltung mit den Leistungstransistoren und den Kühlkörpern einer Temperatur von ca. 230°C ausgesetzt. Aufgrund seiner geringen Masse nimmt der Leistungstransistor sehr schnell die Umgebungstemperatur an. Die Zeitdauer, bis sich der Kühlkörper entsprechend aufgeheizt hat, überschreitet jedoch im allgemeinen die zulässige Höchstdauer, der die Leistungstransistoren einer solchen Temperatur ausgesetzt werden dürfen.

Aus der Druckschrift WO 00/54560 ist ein Verfahren zur Herstellung gedruckter Leiterplatten bekannt, bei dem unterhalb eines zu kühlenden Bauelements eine Bohrung in der Platine angebracht wird, in die ein Metallstift als Wärmesenke eingesetzt wird. Ein Ende des Metallstifts steht über eine Klebstoff- oder Lötmittelverbindung in thermischem Kontakt mit dem zu kühlenden Bauelement. Das andere Ende des Metallstifts kann dabei mit einem großflächigen Kühlkörper verbunden werden. Außerdem ist es aus dieser Druckschrift bekannt, dass der als Wärmesenke fungierende Metallstift in die Öffnung der Platine eingepresst wird. Zu diesem Zweck ist der Metallstift mit radialen Schneidkanten versehen, die für eine mechanische Verbindung des Metallstifts mit der Platine sorgen. Eine ähnliche Anordnung mit einer zylindrischen Wärmesenke ist auch aus der Druckschrift DE 42 20 966 A bekannt.

Die herkömmlichen Wärmesenken lassen jedoch noch Wünsche offen hinsichtlich ihrer Effizienz in der Wärmeabfuhr sowie hinsichtlich der Montage der Gesamtanordnung.

Aufgabe der Erfindung ist es daher, eine einfacher herzustellende Heizvorrichtung mit verbesserter Abfuhr der Verlustwärme anzugeben.

Diese Aufgabe wird mit den Merkmalen des Patentanspruchs 1 gelöst.

Erfindungsgemäß ist das Kühlelement zweiteilig ausgebildet, nämlich aus einem Wärmeleitelement und einem mit dem Wärmeleitelement verbindbaren Kühlkörper. Durch die zweiteilige Ausbildung des Kühlelementes sind die Parameter beider Teile separat einstellbar. Insbesondere ist die Größe, die thermische Masse, die Form und das Material beider Teile individuell auswählbar, so dass bei richtiger Parameterauswahl die Herstellungskosten deutlich reduziert werden können.

Durch die Zweiteilung können beide Teile des Kühlelementes zu unterschiedlichen Zeitpunkten des Herstellungsprozesses mit der Steuerschaltung verbunden werden. Dabei bleibt die insgesamt über das Kühlelement abführbare Wärmemenge im Vergleich zu einer einstückigen Ausgestaltung im wesentlichen unverändert. Durch die Erfindung lässt sich die thermische Masse des Kühlelementes in eine sehr kleine Komponente, das Wärmeleitelement, und eine große Komponente, den Kühlkörper aufteilen. Die kleine thermische Masse wird während des Herstellungsvorgangs jeweils mit den Transistoren verbunden. Ein Rückgriff auf besonders hitzeresistente Transistoren, wie herkömmlich erforderlich, kann dadurch vermieden werden. Die zweite Komponente mit der großen thermischen Masse kann anschließend gefahrlos mit der ersten Komponente verbunden werden. Auf diese Weise ist eine Heizvorrichtung deutlich einfacher und kostengünstiger herstellbar.

Gemäß einer vorteilhaften Ausgestaltung der Erfindung werden die beiden Komponenten des Kühlelementes miteinander verklebt. Auf diese Weise ist eine besonders wirksame und gut wärmeleitende Verbindung in einfacher Weise herstellbar.

Der zur Verklebung beider Komponenten verwendete Kleber bewirkt vorzugsweise außer der mechanisch festen und gut wärmeleitenden Verbindung eine elektrische Isolation beider Teile des Kühlelements, d.h. des Wärmeleitelementes und des Kühlkörpers. Dadurch kann gleichzeitig eine elektrische Isolation des Kühlkörpers von dem Wärmeleitelement erreicht werden, so dass die gewöhnlicherweise auch auf Pluspotential liegende Transistorunterseite nicht an von außen zugänglichen Teilen der Heizvorrichtung anliegt.

Ein weiterer Vorteil dieser Erfindung liegt darin, dass unterschiedliche Materialien für beide Komponenten des Kühlelementes gewählt werden können. So kann beispielsweise für den Kühlkörper ein preiswerteres Material als für das Wärmeleitelement gewählt werden, da nur dann die Verlustwärme in ausreichender Menge abführbar ist, wenn diese über das Wärmeleitelement zum Kühlkörper geleitet werden kann. Auf diese Weise das Kühlelement insgesamt besonders kostengünstig herstellbar, ohne die abführbare Wärmemenge zu vermindern.

In einer bevorzugten Ausführungsform ist das Wärmeleitelement aus Kupfer hergestellt. Kupfer, das eine gute Wärmeleitfähigkeit aufweist, aber relativ teuer ist, muß daher nur an der für die Wärmeleitung besonders kritischen Stelle, nämlich für die Wärmeleitung vom Transistor durch die Platine zum Kühlkörper eingesetzt werden. Ein solches Wärmeleitelement aus Kupfer ist beispielsweise als Pressteil oder Sinterteil besonders preisgünstig herstellbar.

Gemäß einer weiter bevorzugten Ausführungsform ist der Kühlkörper aus Aluminium hergestellt. Aufgrund der großen Kühlkörpermasse wirkt sich die Wahl eines kostengünstigeren Materials besonders vorteilhaft auf die Gesamtherstellungskosten aus. Zudem kann der Kühlkörper dadurch selbst kostengünstig als Stanz-Biege-Teil produziert werden.

Es ist daher ein besonderer Vorteil der vorliegenden Erfindung, dass die zweiteilige Ausbildung des Kühlelementes eine besonders einfache Herstellung jeder der Komponenten ermöglicht, so dass die Herstellungskosten gegenüber einer einteiligen Ausbildung deutlich reduziert sind.

Gemäß einer vorteilhaften Ausführungsform sind die in der Leiterplatte vorgesehene Öffnung und das Wärmeleitelement im wesentlichen zylindrisch ausgebildet. Eine solche Formgebung ermöglicht eine besonders kostengünstige Herstellung.

Gemäß einer bevorzugten Ausführungsform weist der Kühlkörper einen im wesentlichen flachen Abschnitt auf, der an der Leiterplatte anliegt. Dieser Abschnitt ist mit einer Öffnung versehen, durch die ein Ende des Wärmeleitelementes ragt. Das Wärmeleitelement weist an einem durch den flachen Abschnitt des Kühlkörpers ragenden Ende zumindest einen seitlichen Vorsprung auf, durch den der Kühlkörper mechanisch fixiert wird. Bei einer solchen Anordnung kann auf eine Verklebung des Kühlkörpers mit dem Wärmeleitelement verzichtet werden.

Vorzugsweise ist der seitliche Vorsprung zur Fixierung des Kühlkörpers als um das Ende des Wärmeleitelementes umlaufende Wulst ausgebildet. Mit einer solchen Wulst lässt sich eine besonders gute mechanische Fixierung des Kühlkörpers auf einfache Weise erreichen.

In einer vorteilhaften Ausgestaltung der Erfindung strömt die zu erwärmende Luft nicht die Steuervorrichtung als Ganzes an, sondern durch Fensteröffnungen kann der zur Kühlung der Leistungselektronik verwendete Luftdurchsatz gesteuert werden. Vorzugsweise sind die Fensteröffnungen so angeordnet, dass allein die Kühlrippen der Kühlkörper von Außenluft umströmbar sind. Auf diese Weise ist die zur Kühlung der Leistungselektronik verwendete Luftmenge so einstellbar, dass sie keine Zonen unterschiedlicher Temperatur im erwärmten Luftstrom auftreten, dass nämlich der Kühlluftstrom und der von den Radiatorelementen aufgeheizte Luftstrom in etwa dieselbe Ausgangstemperatur aufweisen. Auf diese Weise wird die Effektivität der gesamten Heizvorrichtung nicht durch den zur Kühlung der Steuerelektronik abgezweigten Luftstrom vermindert.

In einer vorteilhaften Ausgestaltung der Erfindung sind innerhalb des Bereichs zwischen gegenüberliegenden Fensteröffnungen Mittel zur Beeinflussung des Luftstroms vorgesehen. Auf diese Weise kann der Luftstrom so gelenkt werden, dass er gezielt die Kühlelemente der Leistungselektronik anströmt, um eine größtmögliche Erwärmung des Kühlluftstromes zu erreichen. Eine besonders vorteilhafte Variante lässt sich mit U-förmig ausgebildeten Kühlelementen erreichen, bei denen zusätzliche Luftleitelemente vorgesehen sein können, die zwischen die Schenkel der U-förmigen Kühlelemente ragen.

Eine weiter verbesserte Abführung von Verlustwärme lässt sich dann erreichen, wenn die Kühlluft auch über die Bauelemente der Steuervorrichtung gelenkt wird. Dazu ist die Platine der Steuervorrichtung vorzugsweise nur einseitig mit Bauelementen bestückt. Auf diese Weise lässt sich ein besonders einfaches Anströmen der Bauelemente erreichen. Zudem ist eine solche Anordnung der Bauelemente auch aus fertigungstechnischen Gründen besonders vorteilhaft.

In einer vorteilhaften Ausführungsform der Erfindung ist die Platine senkrecht zur Rahmenebene des Heizblocks angeordnet. Eine solche Anordnung ermöglicht einerseits ein einfaches Anströmen der Bauelemente. Andererseits lässt sich auf diese Weise eine geringe Bautiefe der elektrischen Heizvorrichtung erreichen.

Um die Gefahr, die von einem auf elektrischen Potential liegenden Kühlkörper mit seinen von außen zugänglichen Oberflächen ausgeht, zu beseitigen, ist die Oberfläche des Kühlkörpers auf der Außenseite mit einer elektrisch isolierenden Beschichtung versehen. Mit einer solchen Maßnahme kann auf einfache Weise ein elektrischer Kurzschluss, beispielsweise durch in den zu erwärmenden/erwärmten Luftstrom fallende Metallteile, verhindert werden.

Vorzugsweise ist der Kühlkörper nur in den Bereichen mit einer elektrisch isolierenden Schicht versehen, die von außen zugänglich sind, insbesondere also den den Fensteröffnungen gegenüberliegenden Kühlrippen.

Bei einer Verklebung beider Komponenten des Kühlelementes können verschiedene Kleber vorteilhaft verwendet werden. Ein Epoxydharzkleber ermöglicht eine besonders feste Verbindung beider Komponenten, insbesondere auch dann, wenn das Kühlelement zusätzlich mit der Leiterplatte verklebt wird. Ein Silikonkleber kann unterschiedliche Ausdehnungskoeffizienten der verklebten Materialien ausgleichen. Ein weiterer vorteilhaft einsetzbarer Kleber ist ein Acrylkleber. Der Vorteil dieser Kleber liegt insbesondere darin, dass keine planparallelen Flächen der Einzelteile, also des Wärmeleitelementes, des Kühlkörpers und der Leiterplatte, erforderlich sind, da Unebenheiten durch die Kleber ausgeglichen werden.

Gemäß einer bevorzugten Ausführungsform ist das Wärmeleitelement so ausgebildet, dass seine Querschnittsfläche vom Transistor zum Kühlkörper zunimmt. Bei einer solchen Ausgestaltung kann mit minimalem Materialeinsatz ein größtmöglicher Effekt erzielt werden. Eine solche Gestaltung des Wärmeleitelementes berücksichtigt, dass sich die von dem Leistungstransistor erzeugte Verlustwärme in Form eines Wärmeleitkegels ausbreitet, wobei der Wärmeleitkegel mit seiner abgeflachten Spitze vom Halbleiterelement des Transistors ausgeht.

Bei einer besonders einfachen Ausgestaltung des Wärmeleitelementes ist dieses im wesentlichen zylindrisch geformt und vorzugsweise in einem in der Öffnung der Leiterplatte angeordneten Abschnitt mit einem kleineren Durchmesser als in einem aus der Leiterplatte herausragenden Abschnitt.

Gemäß einer weiteren vorteilhaften Ausgestaltung des Wärmeleitelementes ist der in der Öffnung der Leiterplatte angeordnete Abschnitt konisch ausgebildet. Eine solche Formgebung ermöglicht einen materialsparenden Einsatz und ein einfaches Einsetzen des Wärmeleitelementes in die Leiterplatte.

Zur besseren mechanischen Fixierung ist das Wärmeleitelement mit radialen Vorsprüngen versehen, die vorzugsweise vertikal ausgerichtet sind. Eine solche Ausgestaltung ermöglicht ein leichtes einsetzen und gleichzeitig eine mechanische Fixierung des Wärmeleitelementes. Dazu ist der Durchmesser der Spitzen der radialen Vorsprünge leicht größer als der Innendurchmesser der Öffnung in der Leiterplatte. Auf diese Weise ist das Wärmeleitelement nach dem Einsetzen sofort in der Leiterplatte mechanisch fixiert.

Der Kühlkörper lässt sich besonders preisgünstig herstellen, wenn er einen im wesentlichen rechteckigen Querschnitt aufweist. Ein erster Abschnitt des Kühlkörpers ist dazu vorzugsweise parallel zur Leiterplatte angeordnet und ein zweiter Abschnitt ragt senkrecht von dem ersten Abschnitt weg.

Zur besseren mechanischen Fixierung des Kühlkörpers ist dieser mit Vertiefungen auf dem aus Leiterplatte herausragenden Ende versehen, die zur Aufnahme des Wärmeleitelementes dienen. Auf diese Weise kann der Kühlkörper gleichzeitig mechanisch auf der Leiterplattefixiert werden, beispielsweise durch Verklebung, und so größeren mechanischen Belastungen aufnehmen, als bei alleiniger Verklebung mit dem Wärmeleitelement.

In einer besonders vorteilhaften Ausgestaltung ist für mehrere Leistungstransistoren mit einer entsprechenden Anzahl von Wärmeleitelementen ein gemeinsamer Kühlkörper vorgesehen. Ein solcher Kühlkörper ist in besonders einfacher Weise und kostengünstig herstellbar. Außerdem ist die Verlustleistung einzelner Leistungstransistoren besser abführbar, insbesondere dann, wenn die Leistungstransistoren eine ungleich Verlustleistung erzeugen.

Weitere vorteilhafte Ausgestaltungen der Erfindung sind in den Unteransprüchen angegeben.

Im folgenden wird die Erfindung anhand der beiliegenden Zeichnungen beschrieben, in denen:
- Fig. 1a und 1b: eine Aufsicht bzw. Seitenansicht einer erfindungsgemäßen elektrischen Heizvorrichtung zeigen,
- Fig. 2: eine Detailansicht der mit Bauelementen bestückten Leiterplatte der Steuervorrichtung zeigt,
- Fig. 3: eine Detailansicht des kastenförmig ausgebildeten Seitenholms und-der in diesen einsetzbaren Steuervorrichtung zeigt,
- Fig. 4: eine weitere Detailansicht des kastenförmig ausgebildeten Seitenholms und der in diesen einsetzbare Steuervorrichtung zeigt,
- Fig. 5a, 5b und 5c: Detailansichten weiterer Ausführungsformen zur Kühlung der Leistungstransistoren zeigen,
- Fig. 6: eine vereinfachte perspektivische Detailansicht einer Realisierung einer weiteren Ausführungsform der Steuervorrichtung gemäß der vorliegenden Erfindung zeigt,
- Fig. 7a, 7b und 7c: verschiedene Detailansichten des Aufbaus der Steuervorrichtung gemäß Fig. 6,
- Fig. 8: eine Detailansicht der Steuervorrichtung mit einem Leistungstransistor und dem diesem zugeordneten Kühlelement zeigt,
- Fig. 9: eine zu Fig. 8 alternative Ausgestaltung des Aufbaus des Kühlelementes zeigt,
- Fig. 10: den vom Halbleiterelement des Leistungstransistors ausgehenden Wärmeableitkegel veranschaulicht,
- Fig. 11: eine vorteilhafte Ausgestaltung des Aufbaus eines Wärmeleitelementes zeigt.
- Fig. 12 und Fig. 13: zeigen eine vorteilhafte Ausgestaltung des Kühlkörpers.

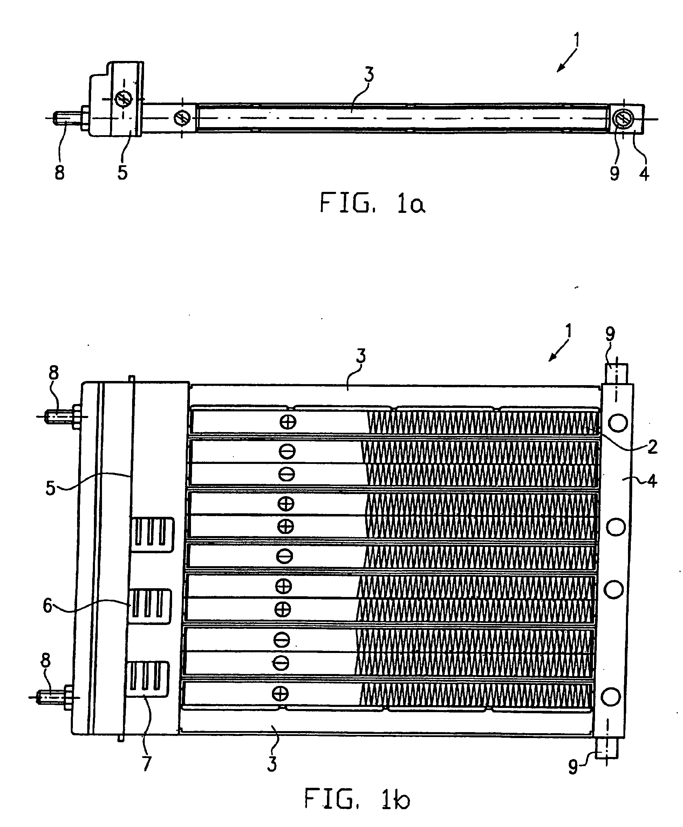

In Fig. 1a ist eine Seitenansicht der erfindungsgemäßen elektrischen Heizvorrichtung 1 gezeigt. Fig. 1b zeigt eine Aufsicht auf die elektrische Heizvorrichtung 1. Die elektrische Heizvorrichtung 1 enthält einen Heizblock, der aus einer Mehrzahl geschichteter oder gestapelter Heizelemente 2 besteht. Jedes Heizelement 2 besteht aus einem Widerstandsheizelement und benachbart dazu angeordneten Radiatoren oder Wärmeleitblechen. Als Widerstandsheizelemente werden vorzugsweise PTC-Elemente verwendet. Der Heizblock aus den Heizelementen 2 wird in einem Rahmen gehalten. Dieser Rahmen besteht aus gegenüberliegenden Längsholmen 3 und senkrecht dazu angeordneten Seitenholmen 4 und 5. Die Holmen des Rahmen sind entweder Metall oder aus Kunststoff gefertigt.

Während die Längsholme 3 im wesentlichen symmetrisch aufgebaut sind, unterscheiden sich die beiden Seitenholme 4 und 5 in der in Fig. 1 dargestellten Ausführungsform.

Im Gegensatz zum Seitenholm 4 ist der Seitenholm 5 als einseitig offener Kasten ausgebildet. Die Öffnung dieses kastenförmigen Seitenholms 5 liegt auf der den Heizelementen 2 gegenüberliegenden Seite des Seitenholms 5. In diesen Kasten ist eine Steuervorrichtung einsetzbar, die die Wärmeabgabe der einzelnen Heizelemente 2 durch Steuerung des den Heizelementen 2 zugeführten Stromes steuert. Die offene Seite des als Kasten ausgebildeten Seitenholms 5 wird nach dem Einsetzen der Steuerschaltung mit einem aufsteckbaren oder aufklipsbaren Deckel verschlossen.

Die Leiterplatte 10 der Steuervorrichtung ist nach dem Einsetzen vorzugsweise senkrecht zur Rahmenebene angeordnet, es ist jedoch auch eine parallele Anordnung möglich (nicht dargestellt).

Die Heizvorrichtung 1 wird über zwei Anschlussbolzen 8 mit Strom versorgt. Sie sind so ausgebildet, dass sie problemlos die geforderten Heizströme leiten können. Die Anschlussbolzen 8 ragen in der in Fig. 1 dargestellten Ausführungsform auf der Seite heraus, auf der der kastenförmige Seitenholm 5 offen ist.

Auf derselben Seite ist ein weiterer Steckersockel zur Ansteuerung der Steuervorrichtung vorgesehen, der in Fig. 1 nicht dargestellt ist.

Der Seitenholm 5 weist auf den Seiten, die in der Flächenebene des Rahmens liegen, Fensteröffnungen 7 auf. Diese Fensteröffnungen 7 sind so angeordnet, dass sie ebenfalls in dem zu erwärmenden Luftstrom liegen. Zwischen den sich gegenüberliegenden Fensteröffnungen 7 sind Kühlelemente 6 angeordnet, die den Leistungselektronikbauelementen der Steuerschaltung zugeordnet sind. Beim Betrieb wird nicht nur der Heizblock aus den Heizelementen 2, sondern ebenfalls die Fensteröffnungen von zu erwärmender Luft durchsetzt.

Die Wahl der Größe der Fensteröffnungen 7 erlaubt, den Anteil der Luftmenge zu bestimmen, die an den Kühlelementen 6 vorbeiströmt. Erfindungsgemäß wird der Luftdurchsatz so eingestellt, dass die durch den Heizblock geströmte Luft und die an den Kühlelementen 6 vorbeigeströmte Luft möglichst geringe Temperaturunterschiede aufweisen. Nur wenn die durch die Fensteröffnungen 7 geströmte Luft in ihrer Temperatur der durch den Heizblock geströmten Luft möglichst nahe kommt, wird eine möglichst hohe Effizienz beim Betrieb der Heizvorrichtung erreicht.

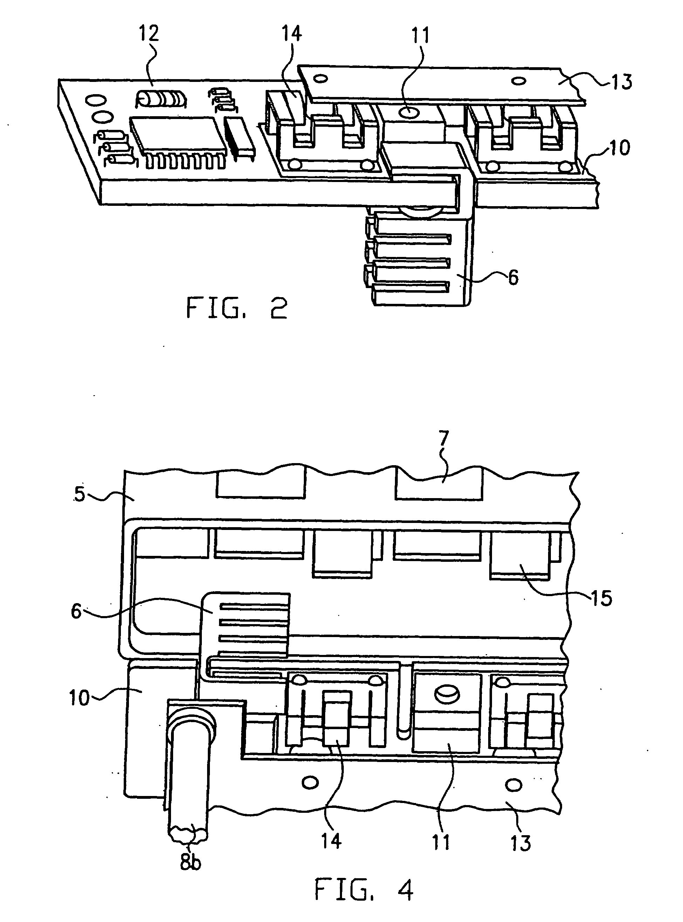

Figur 2 zeigt eine Detailansicht der innerhalb des kastenförmig ausgebildeten Seitenholms angeordneten Steuervorrichtung. Auf einer Leiterplatte 10 ist neben den Leistungselektronikbauelementen 11 eine Steuerelektronik 12 vorgesehen. Die Steuerelektronik 12 bestimmt die von den Leistungselektronikbauelementen 11, insbesondere den Leistungstransistoren, an das diesen jeweils zugeordnete Heizelement 2 abzugebende Strommenge. Die Strommenge wird der Steuerschaltung von einem der Anschlussbolzen 8 über eine Leitungsschiene 13 zugeführt. Der Ausgang des Leistungstransistors 11 ist fest mit der Leiterplatte 10 verlötet und mit einem diesem Transistor zugeordneten Federelement 14 zur Weiterleitung des Stroms an das jeweilige Heizelement verbunden.

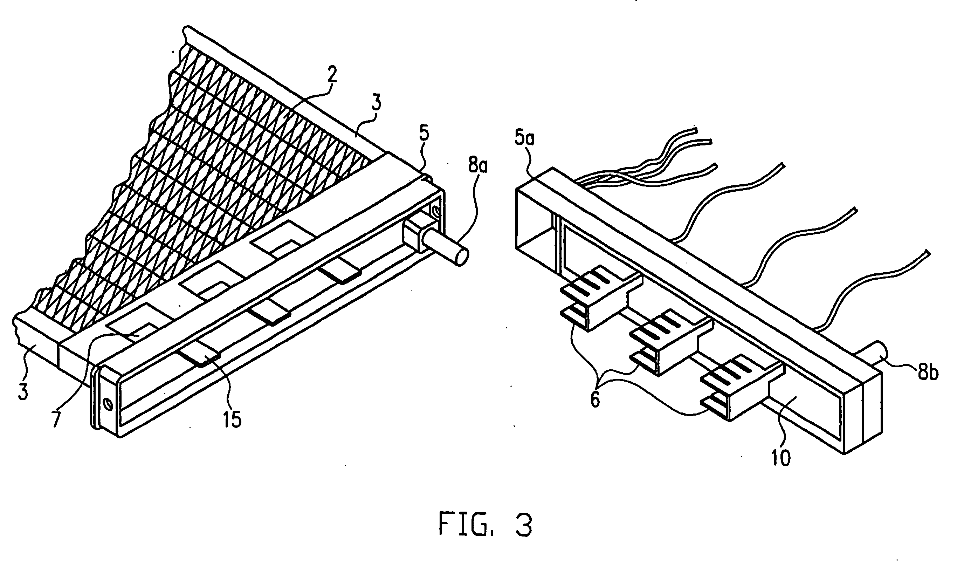

Die Federelemente 14 sind so auf der Leiterplatte angebracht, dass sie beim Zusammenstecken der Steuervorrichtung mit dem Heizblock mit in die Seitenholme 5 ragenden Anschlussfahnen der Heizelemente verbunden sind. Solche Anschlussfahnen 15 sind in den Figuren 3 und 4 zu erkennen.

In der dargestellten Ausführungsform werden die Anschlussfahnen 15 durch die Leiterplatte 10 hindurch in die Federelemente 14 gesteckt. Eine solche Anordnung erlaubt eine feste mechanische Fixierung der Leiterplatte 10 mit der Steuerelektronik in dem Rahmen. Gleichzeitig wird eine elektrische Kontaktierung mit den jeweiligen Heizelementen bewirkt.

Die Leiterplatte ist nur einseitig mit Bauelementen bestückt. Entsprechend der Anzahl von Heizstufen weist die Leiterplatte waagerecht auf dieser befestigte Leistungstransistoren 11 auf. Im gezeigten Ausführungsbeispiel sind drei Heizstufen und dementsprechend drei Leistungstransistoren vorgesehen. Jeder Leistungstransistor 11 ist an seinem Ausgangsanschluss fest mit der Leiterplatte 10 verlötet.

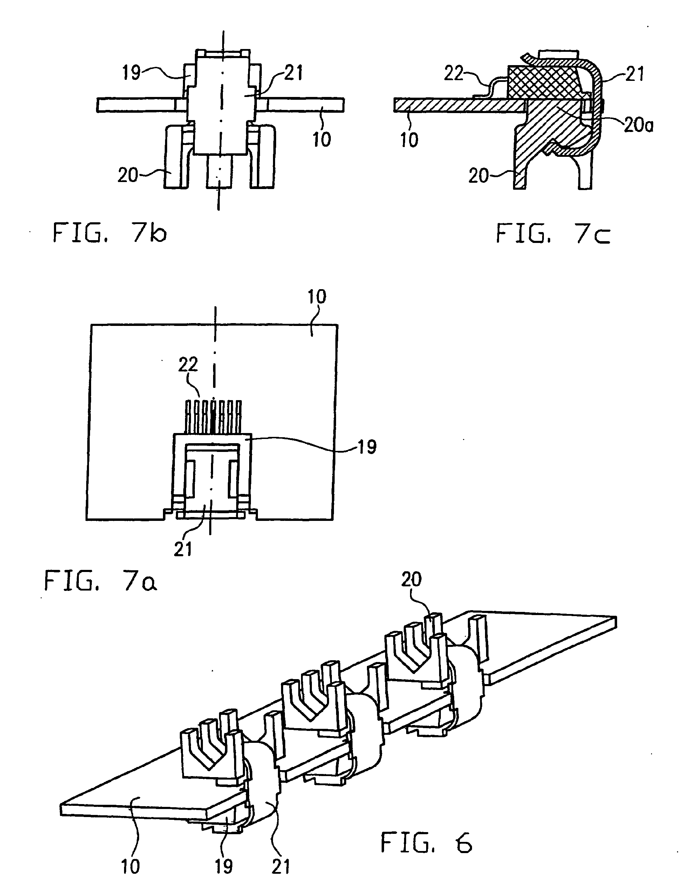

Jeder der Leistungstransistoren ist zur Abführung der Verlustwärme mit einem Kühlelement verbunden. Wie in den Figuren 2 und 6 dargestellt, weist das Kühlelement 6 Kühlrippen auf, die in einer Ebene senkrecht zu der der Leiterplatte angeordnet sind. Die Kühlrippen werden vorzugsweise auf der nicht bestückten Seite der Leiterplatte angeordnet. Zur Abführung der Wärme vom Transistor zum Kühlelement kontaktiert das Kühlelement den Transistor direkt. Eine solche Kontaktierung erfolgt erfindungsgemäß über eine unter dem Transistor angeordnete Öffnung.

Eine entsprechende Anordnung der Bauelemente von Transistor 11, Federelement 14 und Kühlelement 6 ist jeweils für jede Heizstufe auf der Leiterplatte vorgesehen.

Figur 3 zeigt eine Detailansicht des kastenförmig ausgebildeten Seitenholms 5 und der in diesen einsetzbaren Steuerschaltung. Der Seitenholm 5 ist auf einer Seite mit den Längsholmen 3 und dem Heizblock mit den Heizelementen 2 verbunden. Auf der Oberseite des Seitenholms 5 sind die fensterförmigen Öffnungen 7 zu erkennen, durch die die zu erwärmende Luft hindurchtritt.

Innerhalb des kastenförmig ausgebildeten Seitenholms 5 sind drei Anschlusslaschen 15 zu erkennen und ein Anschlussbolzen 8a. Dieser Anschlussbolzen stellt die Plusverbindung für alle Heizelemente 2 dar. Zusätzlich ist in dieser Abbildung in perspektivischer Darstellung die Steuervorrichtung 5a zu erkennen, die in den Kasten des Seitenholmes 5 einsetzbar ist. Die Steuervorrichtung 5a wird mit der dem Seitenholm 5 zugewandten Seite in diesen eingesetzt.

Auf der dem Seitenholm 5 zugewandten Seite der Steuereinrichtung 5a ist die Unterseite der Leiterplatte 10 zu erkennen. Aus der Leiterplatte 10 ragen drei Kühlelemente 6 heraus. Jedes dieser Kühlelemente bzw. Kühlbleche ist einem der Leistungstransistoren 11 einer Heizstufe zugeordnet.

Zu jedem Kühlelement 6 sind entsprechende Fensteröffnungen 7 in der Oberfläche des Seitenholms 5 vorgesehen. Dadurch wird im Betrieb jedem Kühlelement gezielt ein Luftstrom zugeführt.

Auf der nach außen gewandten Seite ist ein weiterer Anschlussbolzen 8b zu erkennen. Dieser Anschlussbolzen dient als elektrischer Massepol bei der Zuführung von Strom. Der Anschlussbolzen 8b ist mit der in den Figuren 2 und 4 dargestellten Leitungsschiene 13 verbunden, die den Heizstrom einzelnen Heizstufen zuführt. Jede einzelne der Heizstufen entnimmt über ihren Leistungstransistor 11 bis zu etwa 40 Ampere der über das Leiterblech 13 zugeführten Strommenge.

In Fig. 4 ist eine weitere perspektivische Detailansicht des Seitenholms 5 und der in die kastenförmige Öffnung des Seitenholms 5 einsteckbaren Steuerschaltung dargestellt.

Im oberen Bereich der Fig. 4 sind auf der Oberfläche des Seitenholms 5 zwei der Fensteröffnungen 7 zu erkennen. Diese Fensteröffnungen sind so angeordnet, dass sie oberund unterhalb der Kühlelemente 6 liegen, wenn die Steuerschaltung in den Seitenholm 5 eingesetzt ist.

Innerhalb der kastenförmigen Öffnung des Seitenholms 5 sind die Anschlusslaschen 15 der Heizelemente 2 zu erkennen. Für jede Heizstufe ist eine Anschlusslasche 15 vorgesehen.

In der unteren Hälfte der Fig. 4 ist die in den Seitenholm 5 einsetzbare Steuerschaltung dargestellt. Nur einer der Leistungstransistoren 11 ist in diesem Fall zur besseren Verdeutlichung des Aufbaus mit einem Kühlelement 6 versehen. Im übrigen entspricht der Aufbau der Steuerschaltung der in Verbindung mit Fig. 2 beschriebenen Steuerschaltung.

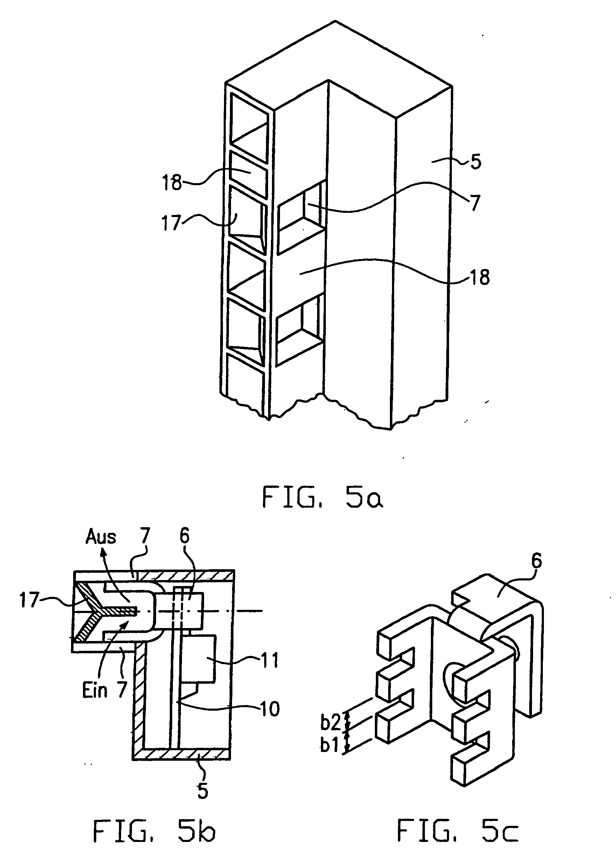

Fig. 5 zeigt eine weitere Ausführungsform, um die Verlustwärme effektiv von den Transistoren abzuführen. Dabei sind in den Figuren 5a, 5b und 5c verschiedene Detailansichten wiedergegeben, und zwar solche, in denen sich diese Ausführungsform besonders von der vorhergehend beschriebenen unterscheidet.

In Fig. 5a ist eine leicht modifizierte Gestaltung des Seitenholms 5 zu erkennen. Dabei entspricht die Anordnung der Fensteröffnungen 7 der zuvor beschriebenen Ausführungsform. Um den Luftstrom gezielter zu beeinflussen, sind zwischen Fensteröffnungen 7 in dem Seitenholm 5 Wände vorgesehen, soweit dies ohne ein Einsetzen der Steuerschaltung in den Seitenholmen 5 zu behindern möglich ist. Dabei werden alle Zwischenräume, die auf der Oberseite zwischen den Fenstern und auf der dem Heizelement zugewandten Seite liegen, mit zusätzlichen Wänden 18 verschlossen. Auf diese Weise wird ein ungezieftes Umherströmen von Luft im Betrieb vermieden.

In den Figuren 5a und 5b ist die Luftführung zwischen den Fensteröffnungen 7 im Detail dargestellt. Dazu ist zur gezielten Luftführung ein Luftleitelement 17 in die zwischen den Fensteröffnungen 7 liegenden Bereiche eingesetzt. Wie in Fig. 5b zu erkennen, erlaubt ein Y-förmiges Spoilerelement ein besseres Umströmen der Kühlrippen ein L- oder U-förmigen Kühlelementes 6. Dabei sind die Kühlrippen des Kühlelementes 6 jeweils benachbart zu den Fensteröffnungen 7 angeordnet.

In Fig. 5b ist außerdem die Leiterplatte 10 mit dem Leistungstransistor 11 angedeutet.

Fig. 5c zeigt eine entsprechende Ausgestaltung des Kühlelementes 6. Während in der zuvor beschriebenen Ausführungsform ein im wesentlichen U-förmig ausgebildetes Kühlelement 6 mit seiner U-förmigen Seite senkrecht auf der Platine steht, ist in dieser Ausführungsform das Kühlelement 6 so angeordnet, dass die U-Form mit ihrer Unterseite parallel zur Leiterplatte 10 angeordnet ist. Entsprechend ist das Y-förmige Luftleitelement 17 so angeordnet, dass es aus der den Heizelementen zugewandten Seite des Seitenholmes 5 in Richtung auf die Steuervorrichtung ragt. Bei Verwendung eines Kühlelementes 6 gemäß der ersten Ausführungsform, können entsprechende Luftleitelemente an den seitlichen Begrenzungen zwischen den gegenüberliegenden Fensteröffnungen 7 angeordnet sein.

In der in Fig. 5c dargestellten Ausführungsform beträgt die Breite b1 einer Kühlrippe etwa 3 mm, während der Abstand b2 zwischen den Kühlrippen etwas weniger, ungefähr 2,5 mm beträgt. Das Kühlelement wird vorzugsweise aus Aluminium oder Kupfer gefertigt.

In den Figuren 6 und 7 ist eine weitere Ausführungsform einer erfindungsgemäßen Steuervorrichtung dargestellt. In dieser Ausführungsform sind insbesondere Alternative Anordnungen der Leistungstransistoren und Kühlelemente wiedergegeben. Die Kühlelemente 20 sind in dieser Ausführungsform in anderer Weise an die Leistungstransistoren angebunden. In den obigen Ausführungsformen sind an den Leistungstransistoren 11 Kühlfahnen angeformt, die an einer Seite aus dem Leistungstransistor herausragen. An diesen Kühlfahnen sind die Kühlelemente der oben beschriebenen Ausführungsformen befestigt. Dabei sind die Kühlfahnen der Leistungstransistoren mit der Leitierplatte verlötet. In der im folgenden beschriebenen Ausführungsform werden die Kühlelemente durch die Leiterplatte 10 hindurch über eine Öffnung direkt an die Unterseite des Transistors 19 angebunden. Die mechanische Fixierung des Kühlelementes kann dabei beispielsweise über eine Verklebung oder auch mittels einer Klemmbefestigung, wie in Fig. 7 dargestellt, erfolgen.

Für eine Klemmbefestigung ist das Kühlelement 20, wie in den Figuren 6 und 7 gezeigt, ausgebildet. Um ein Eingreifen einer Klammer 21 zu ermöglichen, weist das Kühlelement 20 eine unsymmetrische Ausgestaltung der Kühlrippen auf. Dazu sind auf einer Seite des vorzugsweise U-förmig ausgestalteten Kühlelementes weniger Rippen vorgesehen, um ein Eingreifen einer Klammer 21 zu ermöglichen. Die Klammer umgreift vorzugsweise den Leistungstransistor 19 und das Kühlelement 20 von außen und befestigt so die Kühlelemente 20 an der Steuervorrichtung und dem Transistor 19.

Eine direkte Kontaktierung der Leistungstransistoren 19 über eine Bohrung in der Leiterplatte 10 ist insbesondere für Leistungstransistoren in SMD-Ausführung vorteilhaft. Transistoren in SMD-Ausführung weisen bauartbedingt keine Kühlfahnen auf, an denen Kühlelemente befestigbar sind. Um die Kühlelemente mit der Unterseite des Leistungstransistors 19 verbinden zu können, ist in der Leiterplatte eine Öffnung, vorzugsweise eine Bohrung, vorgesehen, durch die ein Teil des Kühlelementes ragt. Eine solche Bohrung hat einen Durchmesser im Bereich von ca. 5 mm bis in etwa 7,5 mm. Die Kühlelemente 20 sind an der der Leiterplatte 10 zugewandten Seite mit einem zapfenartigen Vorsprung 20a ausgebildet. Dieser Zapfen 20a ragt in die in der Leiterplatte unterhalb des Transistors 19 vorgesehene Öffnung. Der Durchmesser des Zapfens 20a es vorzugsweise etwas kleiner als der Innendurchmesser der Bohrung und liegt vorzugsweise im Bereich von etwa 4 mm bis etwa 7 mm.

Dieser Aufbau ist in den Figuren 7a, 7b und 7c im Detail dargestellt. Die Fig. 7a stellt eine Aufsicht auf die Leiterplatte 10 mit dem Leistungstransistor 19 dar. Der Leistungstransistor 19 ist am Rand der Leiterplatte 10 angeordnet, so dass die Klammer 21 zum Befestigen des Kühlelementes 20 leicht zu montieren ist. Die Leiterplatte 10 weist im Bereich der montierten Klammer 21 vorzugsweise eine leichte Ausbuchtung für den Bügel der Klammer 21 auf. Die Tiefe dieser Ausbuchtung entspricht vorzugsweise in etwa der Dicke der Klammer 21. Vorzugsweise ist der Transistor 19 so angeordnet, dass seine Anschlusskontakte 22 nicht in Richtung der Klammer 21 weisen.

In Fig. 7b ist eine seitliche Ansicht wiedergegeben. Figur 7c stellt eine Schnittansicht entlang der Schnittlinie A-A in fig. 7b dar. Fig. 7c zeigt, dass das Kühlelement 20 und die Feder 21 geometrisch so aufeinander abgestimmt sind, dass eine lagegerechte Fixierung mit optimalen Druckpunkt gewährleistet ist.

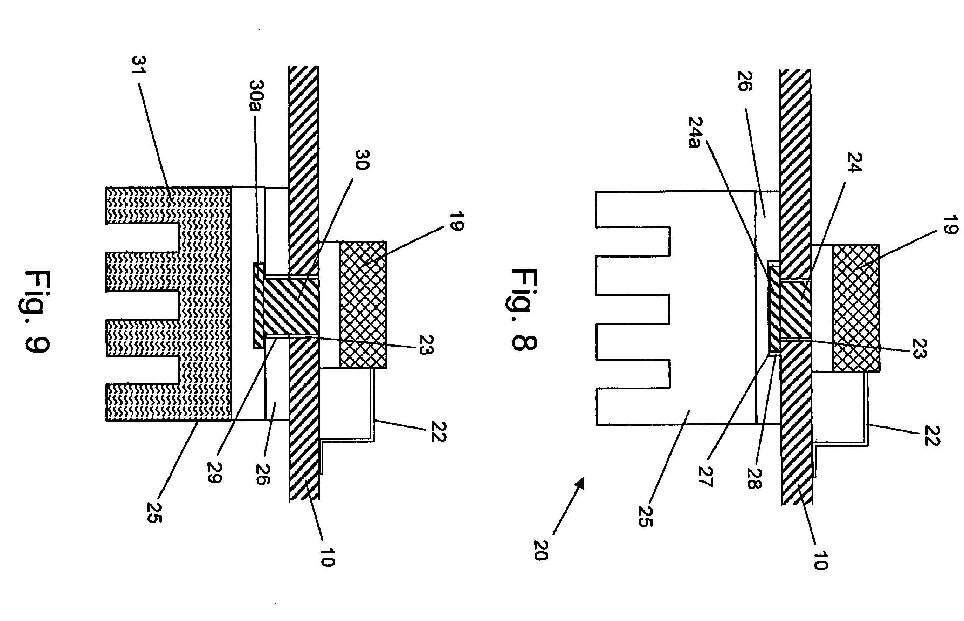

Eine weiter verbesserte Ausführungsform des in Fig. 7c gezeigten Kühlelementes 20 ist in Fig. 8 und Fig. 9 in zwei alternativen Ausgestaltungen gezeigt. Das in Fig. 7c gezeigte Kühlelement 20 besitzt eine relativ große Masse und kompliziert dadurch den Herstellungsprozess und schränkt durch die für die Herstellung erforderliche Hitzebeständigkeit der Transistoren die zur Verfügung stehende Auswahl an Transistortypen deutlich ein.

In Fig. 8 und Fig. 9 sind zwei alternative Ausgestaltungen eines Kühlelementes gezeigt, die die beim Herstellungsvorgang so problematische große thermische Masse des Kühlelementes 20 durch einen zweiteiligen Aufbau deutlich vermindern.

Das Kühlelement 20 ist dazu in zwei miteinander verbundene Komponenten unterteilt, nämlich ein Wärmeleitelement 24 und einen Kühlkörper 25. Das Wärmeleitelement 24 wird in die Bohrung 23 der Leiterplatte 10 eingesetzt. Während des Herstellungsprozesses wird die Aufwärmzeitdauer durch die geringe thermische Masse des Wärmeleitelementes 24 nicht verzögert. Dementsprechend müssen an die Hitzebeständigkeit des Leistungstransistors 19 in diesem Fall keine besonderen Anforderungen gestellt werden.

Mit dem Wärmeleitelement 24 ist ein Kühlkörper 25 auf der dem Transistor gegenüberliegenden Seite der Leiterplatte 10 wärmeleitend verbunden. Der Kühlkörper 20 besitzt eine große thermische Masse mit Kühlrippen, um die von dem Leistungstransistor 19 erzeugte Verlustwärme wirksam abführen zu können.

Gemäß einer besonderen Ausgestaltung der Erfindung besitzt das Wärmeleitelement 24 eine zylindrische Form. Vorteilhafterweise besteht das Wärmeleitelement 24 aus zwei Abschnitten. Ein erster Abschnitt, der in die Bohrung 23 in der Leiterplatte 10 einsetzbar ist und den Transistor 19 kontaktiert, besitzt eine kleinere Querschnittsfläche, während ein zweiter Abschnitt 24a an dem aus der Platine herausragenden Ende des Wärmeleitelementes eine größere Querschnittsfläche besitzt.

Der zweite Abschnitt 24a des Wärmeleitelementes wird mit dem Kühlkörper 25 wärmeleitend kontaktiert. Der Kühlkörper 25 besitzt einen im wesentlichen flachen Abschnitt 26, der mit dem Wärmeleitelement 24 und ggf. mit der Leiterplatte 10 verbindbar ist, und senkrecht von dem Abschnitt 26 nach Außen ragende Kühlrippen. Der Abschnitt 26 des Kühlkörpers besitzt eine Vertiefung 28, an der dem Wärmeleitelement 24 zugewandten Seite. Diese Vertiefung dient zur Aufnahme des aus der Leiterplatte 10 herausragenden Abschnitts 24a des Wärmeleitelementes.

Das Wärmeleitelement 24 und der Kühlkörper 25 werden vorzugsweise verklebt. Die Verklebung beider Teile 24 und 25 des Kühlelementes erfolgt vorzugsweise mit einem Epoxydharzkleber, einem Siliconkleber oder einem Acrylkleber. Ein Epoxydharzkleber ermöglicht eine besonders feste Verbindung beider Komponenten. Der Silikonkleber kann unterschiedliche Ausdehnungskoeffizienten der verklebten Materialien ausgleichen, insbesondere dann, wenn der Kühlkörper 25 zusätzlich auch mit der Leiterplatte 10 zur Erhöhung der mechanischen Belastbarkeit des Kühlkörpers verbunden wird. Diese Kleber besitzen insbesondere den Vorteil, dass bei den verklebten Komponenten keine planparallelen Flächen erforderlich sind, da Unebenheiten durch den Kleberstoff selbst ausgeglichen werden.

Vorzugsweise bewirkt der verwendete Kleber gleichzeitig eine elektrische Isolierung der beiden miteinander verklebten Komponenten 24, 25 des Kühlelementes 20. Während das Wärmeleitelement 24 auf dem Potential des Ausgangsanschlusses des Transistors 19 liegt, im allgemeinen auf Pluspotential, ist der Kühlkörper 25 potentialfrei. Die Kühlrippen des Kühlkörpers 25 sind zur Wärmeabführung so angeordnet, dass sie von außen freizugänglich sind. Durch eine elektrisch isolierende (aber gut wärmeleitende) Verbindung beider Komponenten wird jede Gefahr eines Kurzschlusses durch auf die Heizvorrichtung fallende und die Kühlrippen berührende Metallteile ausgeschlossen. Dadurch kann die Betriebssicherheit der Heizvorrichtung deutlich erhöht werden.

Fig. 9 zeigt einen alternativen Aufbau für das zweiteilige Kühlelement 20. Das Wärmeleitelement 30 ist hier so ausgebildet, dass es zusätzlich zu der Leiterplatte 20 auch durch den an der Leiterplatte 10 anliegenden Abschnitt 26 des Kühlkörpers 25 ragt. An dem aus dem Abschnitt 26 hinausragenden Teil des Wärmeleitelementes 30 ist zumindest ein seitlicher Vorsprung, vorzugsweise eine seitlich umlaufende Wulst 30a, zur mechanischen Fixierung des Kühlkörpers mit seinem Abschnitt 26 an der Leiterplatte 10 vorgesehen. Bei einer solchen Ausgestaltung ist eine Verklebung beider Komponenten nicht erforderlich.

Um eine elektrische Isolierung des Kühlkörpers 25 zu erreichen, wird dieser an seiner Oberfläche mit einer elektrisch isolierenden Beschichtung 31 versehen. Vorzugsweise ist diese Beschichtung nur an den Stellen der Oberfläche angebracht, die von außen frei zugänglich sind, die beispielsweise in den Fensteröffnungen 7 liegen. Eine solche Beschichtung 31 kann zusätzlich zu einer elektrischen Isolation mittels eines Klebstoffs gemäß der in Fig. 8 dargestellten Ausführungsform zur Erzielung einer größeren Ausfallsicherheit eingesetzt werden.

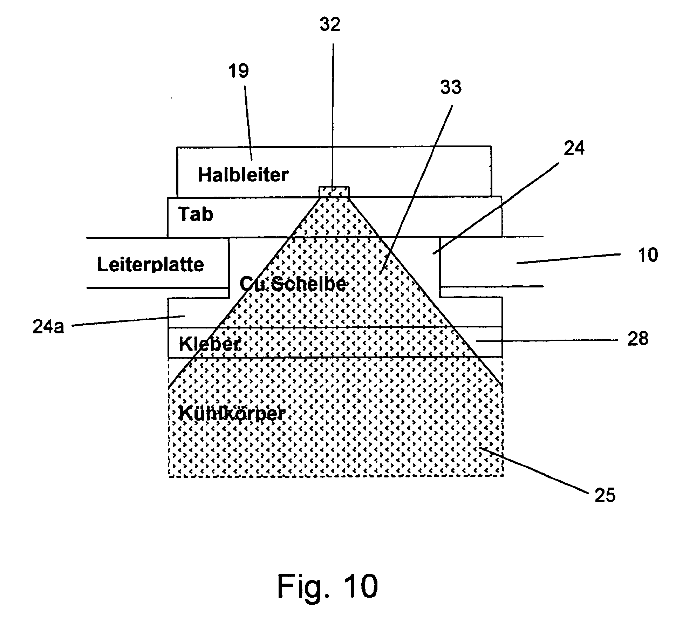

Weitere Randbedingungen für eine Ausgestaltung des Wärmeleitelementes 24 werden nachfolgend unter Bezugnahme auf Fig. 10 beschrieben. Die abzuführende Verlustwärme des Transistors 19 wird im Halbleiterelement 32 des Transistors erzeugt. Ausgehend von dem Halbleiterelement 32 kann die Verlustwärme über den in Fig. 10 nur prinzipiell angedeuteten "Wärmeleitkegel" 33 abgeführt werden. Die tatsächliche Form des Wärmeleitkegels 33 hängt von den jeweiligen konkreten Gegebenheiten ab. Wenn die Wärme vom Halbleiterelement 32 zum Kühlkörper 25 nur über einen solchen Wärmeleitkegel 33 abführbar ist, so kann auch eine noch so große Querschnittsfläche des Wärmeleitelementes 24 keine Verbesserung der Wärmeableitung bewirken. Das Wärmeleitelement 24 wird deshalb vorzugsweise mit einer Form ausgebildet, die sich an den Wärmeleitkegel 33 anlehnt. Dazu ist das Wärmeleitelement 24 vorteilhafterweise mit entsprechend größer werdenden Querschnittsflächen in zunehmendem Abstand vom Transistor ausgebildet. Dazu ist das Wärmeleitelement in einer einfach herzustellenden Variante mit einem kleineren Querschnitt innerhalb der Leiterplatte und mit einem größeren Querschnitt in dem aus der Leiterplatte 10 herausragende Abschnitt 24a gestaltet. Vorzugsweise ist das Wärmeleitelement 24 zylindrisch geformt.

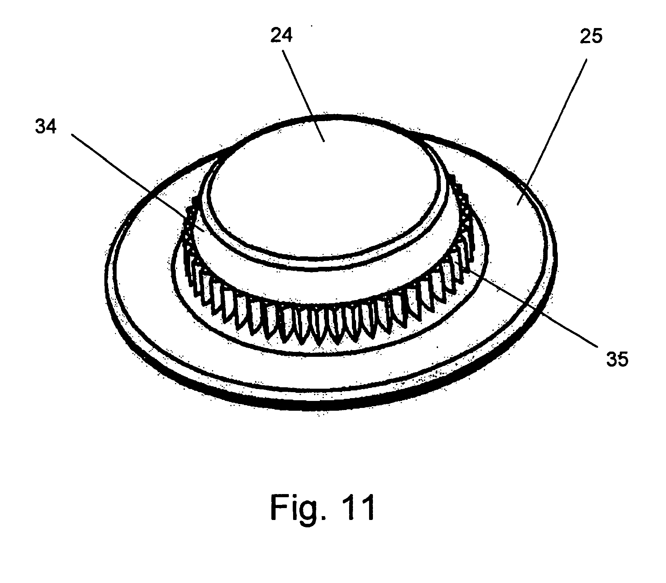

Eine weitere beispielhafte Ausgestaltung der Wärmeleitscheibe 24 ist in Fig. 11 wiedergegeben. Die Wärmeleitscheibe 24 besteht aus zwei im wesentlichen zylindrisch geformten Abschnitten, einem ersten Abschnitt, der in die Leiterplatte 10 einsetzbar ist und eine zylindrische Form mit einem kleineren Durchmesser aufweist, und einem zweiten Abschnitt 25, der aus der Leiterplatte 10 herausragt und eine zylindrische Form mit einem deutlich größeren Durchmesser aufweist. Der in die Leiterplatte 10 einsetzbare erste Abschnitt weist vorzugsweise eine leicht konische Form auf. Auf diese Weise wird das Einsetzen der Wärmeleitscheibe erleichtert und die Form der Wärmeleitscheibe ist besser an den Wärmeleitkegel 33 (vgl. Fig. 10) angepasst.

In der in Fig. 11 dargestellten Ausführungsform sind zusätzlich am Umfang des in die Leiterplatte 10 einsetzbaren Abschnitts radiale Vorsprünge 35 angeordnet. Diese Vorsprünge 35 besitzen jeweils eine Keilform mit einer nach außen ragenden Spitze. Die Vorsprünge 35 sind so ausgebildet, dass ihre Spitzen leicht größer als der Innendurchmesser der Öffnung 23 in der Leiterplatte 10 ausgebildet sind. Dadurch ist das Wärmeleitelement 24 nach dem Einsetzen in die Leiterplatte mechanisch in dieser fixiert. Das Einsetzen des Wärmeleitelementes wird dadurch erleichtert, dass die Vorsprünge 35 jeweils eine vertikale Ausrichtung aufweisen. Gegebenfalls sind die Vorsprünge 35 entsprechend zu der konischen Form des ersten Abschnittes leicht geneigt, um ein Einsetzen der Wärmeleitscheibe 24 in die Leiterplatte 10 zu erleichtern.

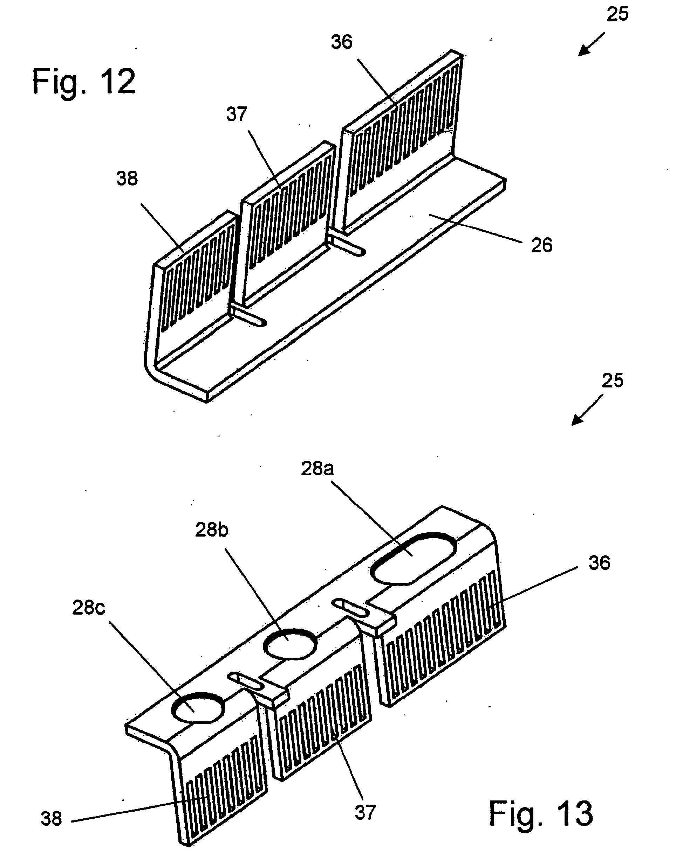

Fig. 12 und Fig. 13 zeigen eine besondere Ausgestaltung des Kühlkörpers 25. Der Kühlkörper 25 besteht vorzugsweise aus einem im wesentlichen zweiteiligen Aufbau mit einem im flachen Abschnitt 26 und einem senkrecht zu diesem ausgerichteten Kühlrippenabschnitt 36, 37, 38. Vorzugsweise ist der Kühlkörper 25 rechtwinklig ausgebildet, so dass er einfach und kostengünstig als Stanz-Biege-Teil herstellbar ist.

In Fig. 13 sind Vertiefungen 28a, 28b, 28c erkennbar, die auf der an der Leiterplatte 10 anliegenden Seite des Abschnitts 26 vorgesehen sind. Diese Vertiefungen dienen dazu, den aus der Leiterplatte 10 herausragenden Abschnitt 24a des Wärmeleitelementes 24 aufzunehmen.

Gemäß der in Fig. 12 und Fig. 13 gezeigten besonders bevorzugten Ausführungsform ist der Kühlkörper 25 einstückig für mehrere Leistungstransistoren 19 (und dementsprechende Wärmeleitelemente 24) ausgebildet. Dadurch wird die Herstellung des Kühlkörpers 25 weiter vereinfacht. Außerdem kann durch die größere thermische Masse des Kühlkörpers 25 die Verlustwärme der einzelnen Leistungstransistoren 19 besser abgeführt werden, wenn die individuelle Verlustleistung der Transistoren unterschiedlich groß ist.

Zusammenfassend betrifft die vorliegende Erfindung eine elektrische Heizvorrichtung als Zusatzheizung für Kraftfahrzeuge, bei der das Heizregister und die Steuervorrichtung zu einer baulichen Einheit integriert sind. Zur Ansteuerung der Heizelemente des Heizregisters sind direkt auf der Leiterplatte montierte Leistungstransistoren vorgesehen. Zur effizienten Abführung der Verlustwärme von den Leistungstransistoren werden diese direkt über Öffnungen in der Leiterplatte an ihrer Unterseite mit einem Kühlelement kontaktiert. Um die Herstellung zu vereinfachen, sind die Kühlelemente zweiteilig ausgebildet, und zwar aus einer Wärmeleitscheibe mit einer kleinen thermischen Masse, die in die Öffnung der Leiterplatte einsetzbar ist, und einem mit diesem Wärmeleitelement verbindbaren Kühlkörper.

## Patentansprüche

1. Elektrische Heizvorrichtung, insbesondere als Zusatzheizung für Kraftfahrzeuge, mit mehreren zu einem Heizblock zusammengesetzten Heizelementen (2) und einer Steuervorrichtung zur Ansteuerung der Heizelemente (2), wobei die Steuervorrichtung mit dem Heizblock eine bauliche Einheit bildet, auf einer Leiterplatte (10) angeordnete Leistungstransistoren (19) und diesen zugeordnete Kühlelemente aufweist und ein Kühlelement jeweils durch eine Öffnung (23) in der Leiterplatte (10) an den jeweiligen Leistungstransistor (19) angebunden ist,
**dadurch gekennzeichnet, dass**
das Kühlelement aus einem Kühlkörper (25) und einem in die Öffnung (23) der Leiterplatte (10) einsetzbaren Wärmeleitelement (24) gebildet ist,
das Wärmeleitelement (24) einen ersten Abschnitt und einen zweiten Abschnitt (24a) besitzt, wobei der erste Abschnitt in die Öffnung (23) der Leiterplatte (10) einsetzbar ist und der zweite Abschnitt (24a) eine größere Querschnittsfläche als der erste Abschnitt besitzt, und
der erste Abschnitt des Wärmeleitelements (24) radiale Vorsprünge (35) zur mechanischen Fixierung des Wärmeleitelementes (24) in der Öffnung (23) der Leiterplatte (10) aufweist.

2. Elektrische Heizvorrichtung nach Anspruch 1, **dadurch gekennzeichnet, dass** das Wärmeleitelement (24) mit dem Kühlkörper (25) verklebt ist.

3. Elektrische Heizvorrichtung nach Anspruch 2, **dadurch gekennzeichnet, dass** der zur Verklebung von Wärmeleitelement (24) und Kühlkörper (25) verwendete Kleber (28) eine elektrische Isolation des Wärmeleitelementes (24) und des Kühlkörper (25) bewirkt.

4. Elektrische Heizvorrichtung nach einem der Ansprüche 1 bis 3, **dadurch gekennzeichnet, dass** das Wärmeleitelement (24) aus Kupfer hergestellt ist.

5. Elektrische Heizvorrichtung nach einem der Ansprüche 1 bis 4, **dadurch gekennzeichnet, dass** der Kühlkörper (25) aus Aluminium hergestellt ist.

6. Elektrische Heizvorrichtung nach einem der Ansprüche 1 bis 5, **dadurch gekennzeichnet, dass** die Masse des Wärmeleitelementes (24) sehr viel kleiner als die des Kühlkörpers (25) ist.

7. Elektrische Heizvorrichtung nach einem der Ansprüche 1 bis 6, **dadurch gekennzeichnet, dass** die in der Leiterplatte (10) vorgesehene Öffnung (23) und das Wärmeleitelement (24) im wesentlichen zylindrisch geformt sind.

8. Elektrische Heizvorrichtung nach einem der Ansprüche 1 bis 7, **dadurch gekennzeichnet, dass**
der Kühlkörper (25) einen im wesentlichen flachen Abschnitt (26) mit einer Öffnung (29) aufweist,
das Wärmeleitelement (30) durch die Öffnung (29) in dem flachen Abschnitt (26) des Kühlkörpers (25) ragt und
das Wärmeleitelement (30) zur mechanischen Fixierung des Kühlkörpers (25) zumindest einen seitlichen Vorsprung (30a) an dem durch den Kühlkörper (25) und aus diesem herausragenden Ende aufweist.

9. Elektrische Heizvorrichtung nach Anspruch 8, **dadurch gekennzeichnet, dass** der seitliche Vorsprung (30a) eine seitlich um das herausragende Ende des Wärmeleitelements (30) umlaufende Wulst ist.

10. Elektrische Heizvorrichtung nach einem der Ansprüche 1 bis 9, **dadurch gekennzeichnet, dass** die Kühlkörper (25) in der Heizvorrichtung so angeordnet sind, dass sie jeweils über in einem Gehäuse der Heizvorrichtung vorgesehene Fensteröffnungen (7) von der zu erwärmenden Luft umströmbar sind.

11. Elektrische Heizvorrichtung nach einem der Ansprüche 1 bis 10, **dadurch gekennzeichnet, dass** die Oberfläche der Kühlkörper (25) auf der Außenseite mit einer elektrisch isolierenden Beschichtung (31) versehen ist.

12. Elektrische Heizvorrichtung nach Anspruch 10 und 11, **dadurch gekennzeichnet, dass** die Oberfläche der Kühlkörper (25) im wesentlichen nur in dem den Fensteröffnungen (7) gegenüberliegenden Bereich mit einer elektrisch isolierenden Beschichtung (31) versehen ist.

13. Elektrische Heizvorrichtung nach einem der Ansprüche 2 bis 12, **dadurch gekennzeichnet, dass** der Kleber (28) ein Epoxydharzkleber, eine Silikonkleber oder ein Acrylkleber ist.

14. Elektrische Heizvorrichtung nach einem der Ansprüche 1 bis 13, **dadurch gekennzeichnet, dass** das Wärmeleitelement (24) mit zunehmendem Abstand vom Leistungstransistor (19) eine größere Querschnittsfläche aufweist.

15. Elektrische Heizvorrichtung nach Anspruch 14, **dadurch gekennzeichnet, dass** das Wärmeleitelement (24) im wesentlichen zylindrisch ausgebildet ist.

16. Elektrische Heizvorrichtung nach Anspruch 15, **dadurch gekennzeichnet, dass** der in der Öffnung (29) der Leiterplatte (10) angeordnete Abschnitt (34) des Wärmeleitelementes (24) eine im wesentlichen konische Form aufweist, die sich in Richtung auf das den Leistungstransistor (19) kontaktierende Ende verjüngt.

17. Elektrische Heizvorrichtung nach einem der Ansprüche 1 bis 16, **dadurch gekennzeichnet, dass** der Kühlkörper (25) einen im wesentlichen rechteckigen Querschnitt mit einem ersten Abschnitt (26), der parallel zur Leiterplatte (10) angeordnet ist, und einem senkrecht dazu angeordneten zweiten Abschnitt (36-38) umfasst.

18. Elektrische Heizvorrichtung nach Anspruch 17 **dadurch gekennzeichnet, dass** der erste Abschnitt (26) des Kühlkörpers (25) auf der der Leiterplatte (10) zugewandten Seite Vertiefungen (28a-28c) zur Aufnahme des aus der Leiterplatte (10) herausragenden Endes des Wärmeleitelementes (24) aufweist.

19. Elektrische Heizvorrichtung nach Anspruch 17 oder 18, **dadurch gekennzeichnet, dass** die Kühlkörper (25) mehrerer benachbarter Kühlelemente einstückig ausgebildet sind.

20. Elektrische Heizvorrichtung nach Anspruch 19, **dadurch gekennzeichnet, dass** die einstückig ausgebildeten Kühlkörper (25) über den ersten Abschnitt (26) miteinander verbunden sind.

## Claims

1. Electric heating device, in particular as supplemental heating for motor vehicles, with several heating elements (2) forming a heater block, a control unit for controlling the heating elements (2), whereby the control unit forms a structural unit with the heater block, power transistors (19) arranged on a circuit board (10), and cooling elements allocated to these power transistors, each of these cooling elements being connected through an opening (23) in the circuit board (10) to the respective power transistor (19),
**characterised in that**
the cooling element is formed from a cooling body (25) and a heat-conducting element (24) insertable into the opening (23) of the circuit board (10),
the heat-conducting element (24) comprises a first section and a second section (24a), wherein the first section is insertable into the opening (23) of the circuit board (10) and a cross-section area of the second section (24a) is larger than that of the first section, and
the first section of the heat-conducting element (24) has radial projections (35) for mechanical fastening of the heat-conducting element (24) in the opening (23) of the circuit board (10).

2. Electric heating device according to Claim 1, **characterised in that** the heat-conducting element (24) is glued to the cooling body (25).

3. Electric heating device according to Claim 2, **characterised in that** the glue (28) used to glue the heat-conducting element (24) and the cooling body (25) produces an electric insulation of the heat-conducting element (24) and the cooling body (25).

4. Electric heating device according to any of Claims 1 to 3, **characterised in that** the heat-conducting element (24) is made of copper.

5. Electric heating device according to any of Claims 1 to 4, **characterised in that** the cooling body (25) is made of aluminium.

6. Electric heating device according to any of Claims 1 to 5, **characterised in that** the mass of the heat-conducting element (24) is very much smaller than that of the cooling body (25).

7. Electric heating device according to any of Claims 1 to 6, **characterised in that** the opening (23) provided in the circuit board (10) and the heat-conducting element (24) are essentially cylindrically formed.

8. Electric heating device according to any of Claims 1 to 7, **characterised in that** the cooling body (25) has an essentially flat section (26) with an opening (29),
the heat-conducting element (30) protrudes through the opening (29) in the flat section (26) of the cooling body (25), and
the heat-conducting element (30) has at least one lateral projection (30a) on the end protruding through the cooling body (25) and out of the latter for mechanical fastening of the cooling body (25).

9. Electric heating device according to Claim 8, **characterised in that** the lateral projection (30a) is a bulb laterally fitting around the protruding end of the heat-conducting element (30).

10. Electric heating device according to any of Claims 1 to 9, **characterised in that** the cooling bodies (25) are arranged in the heating device such that the air to be heated can be blown around them via window openings (7) provided in a housing of the heating device.

11. Electric heating device according to any of Claims 1 to 10, **characterised in that** the surface of the cooling bodies (25) is provided on the outside with an electrically insulating coating (31).

12. Electric heating device according to Claim 10 or 11, **characterised in that** the surface of the cooling bodies (25) is provided with an electrically insulating coating (31) essentially only in the region opposite the window openings (7).

13. Electric heating device according to any of Claims 2 to 12, **characterised in that** the glue (28) is an epoxy resin glue, a silicon glue or an acrylic glue.

14. Electric heating device according to any of Claims 1 to 13, **characterised in that** the heat-conducting element (24), as the distance from the power transistor (19) increases, has a larger cross-section area.

15. Electric heating device according to Claim 14, **characterised in that** the heat-conducting element (24) is essentially formed cylindrically.

16. Electric heating device according to Claim 15, **characterised in that** the section (34) of the heat-conducting element (24) arranged in the opening (29) of the circuit board (10) has an essentially conical shape growing smaller in the direction of the end in contact with the power transistor (19).

17. Electric heating device according to Claim 1 **characterised in that** the cooling body (25) comprises an essentially rectangular cross-section with a first section (26) arranged parallel to the circuit board (10) and a second section (36-38) arranged vertically thereto.

18. Electric heating device according to Claim 17, **characterised in that** the first section (26) of the cooling body (25) has recesses (28a-28c) on the side facing the circuit board (10) for accommodating the end of the heat-conducting element (24) protruding from the circuit board (10).

19. Electric heating device according to Claim 17 or 18, **characterised in that** the cooling bodies (25) of several adjacent cooling elements are formed in one piece.

20. Electric heating device according to Claim 19, **characterised in that** the cooling bodies (25) formed in one piece are connected to each other via the first section (26).

## Revendications

1. Dispositif de chauffage électrique, en particulier en tant que chauffage d'appoint pour véhicule automobile, avec plusieurs éléments chauffants (2) assemblés en un bloc chauffant et un dispositif de commande pour piloter les éléments chauffants (2), dans lequel le dispositif de commande forme avec le bloc chauffant une unité de construction, présente des transistors de puissance (19) disposés sur une carte de circuit imprimé (10) et des éléments de refroidissement qui leur sont associés, et un élément de refroidissement est respectivement relié au transistor de puissance (19) respectif à travers une ouverture (23) dans la plaque de circuits imprimés (10),
**caractérisé en ce que**
l'élément de refroidissement est formé à partir d'un dissipateur thermique (25) et d'un élément thermoconducteur (24) pouvant s'insérer dans l'ouverture (23) de la carte de circuit imprimé (10),
l'élément thermoconducteur (24) possède une première partie et une deuxième partie (24a), dans lequel la première partie peut être insérée dans l'ouverture (23) de la carte de circuit imprimé (10), et la deuxième partie (24a) possède une plus grande superficie de section que la première partie, et
la première partie de l'élément thermoconducteur (24) présente des saillies radiales (35) pour la fixation mécanique de l'élément thermoconducteur (24) dans l'ouverture (23) de la carte de circuit imprimé (10).

2. Dispositif de chauffage électrique selon la revendication 1, **caractérisé en ce que** l'élément thermoconducteur (24) est collé avec le dissipateur thermique (25).

3. Dispositif de chauffage électrique selon la revendication 2, **caractérisé en ce que** l'adhésif (28) utilisé pour coller l'élément thermoconducteur (24) et le dissipateur thermique (25) provoque une isolation électrique de l'élément thermoconducteur (24) et du dissipateur thermique (25).

4. Dispositif de chauffage électrique selon l'une des revendications 1 à 3, **caractérisé en ce que** l'élément thermoconducteur (24) est fait en cuivre.

5. Dispositif de chauffage électrique selon l'une des revendications 1 à 4, **caractérisé en ce que** le dissipateur thermique (25) est fait en aluminium.

6. Dispositif de chauffage électrique selon l'une des revendications 1 à 5, **caractérisé en ce que** la masse de l'élément thermoconducteur (24) est très inférieure à celle du dissipateur thermique (25).

7. Dispositif de chauffage électrique selon l'une des revendications 1 à 6, **caractérisé en ce que** l'ouverture (23) prévue dans la carte de circuit imprimé (10) et l'élément thermoconducteur (24) sont formés de façon essentiellement cylindrique.

8. Dispositif de chauffage électrique selon l'une des revendications 1 à 7, **caractérisé en ce que**
le dissipateur thermique (25) présente une partie (26) essentiellement plate avec une ouverture (29),
l'élément thermoconducteur (30) fait saillie à travers l'ouverture (29) dans la partie plate (26) du dissipateur thermique (25), et
l'élément thermoconducteur (30) présente pour la fixation mécanique du dissipateur thermique (25) au moins une saillie latérale (30a) au niveau de l'extrémité faisant saillie à travers le dissipateur thermique (25) et vers l'extérieur de celui-ci.

9. Dispositif de chauffage électrique selon la revendication 8, **caractérisé en ce que** la saillie latérale (30a) est un bourrelet s'étendant latéralement autour de l'extrémité en saillie de l'élément thermoconducteur (30).

10. Dispositif de chauffage électrique selon l'une des revendications 1 à 9, **caractérisé en ce que** les dissipateurs thermiques (25) dans le dispositif de chauffage sont disposés de telle sorte que l'air à réchauffer peut s'écouler autour de ceux-ci respectivement à travers des ouvertures découpées (7) prévues dans un boîtier du dispositif de chauffage.

11. Dispositif de chauffage électrique selon l'une des revendications 1 à 10, **caractérisé en ce que** la surface des dissipateurs thermiques (25) est munie sur la face extérieure d'un revêtement (31) électriquement isolant.

12. Dispositif de chauffage électrique selon la revendication 10 et 11, **caractérisé en ce que** la surface des dissipateurs thermiques (25) est munie essentiellement seulement dans la zone opposée aux ouvertures découpées (7) d'un revêtement électriquement isolant (31).

13. Dispositif de chauffage électrique selon l'une des revendications 2 à 12, **caractérisé en ce que** l'adhésif (28) est un adhésif époxy, un adhésif silicone ou un adhésif acrylique.

14. Dispositif de chauffage électrique selon l'une des revendications 1 à 13, **caractérisé en ce que** l'élément thermoconducteur (24) présente une plus grande superficie de section à mesure que la distance par rapport au transistor de puissance (19) augmente.

15. Dispositif de chauffage électrique selon la revendication 14, **caractérisé en ce que** l'élément thermoconducteur (24) est réalisé de façon essentiellement cylindrique.

16. Dispositif de chauffage électrique selon la revendication 15, **caractérisé en ce que** la partie (34) disposée dans l'ouverture (29) de la carte de circuit imprimé (10) de l'élément thermoconducteur (24) présente une forme essentiellement conique qui s'amincit en direction de l'extrémité touchant le transistor de puissance (19).

17. Dispositif de chauffage électrique selon l'une des revendications 1 à 16, **caractérisé en ce que** le dissipateur thermique (25) comprend une section transversale essentiellement rectangulaire avec une première partie (26) qui est disposée en parallèle à la carte de circuit imprimé (10) et une deuxième partie (36 à 38) disposée perpendiculairement à celle-ci.

18. Dispositif de chauffage électrique selon la revendication 17, **caractérisé en ce que** la première partie (26) du dissipateur thermique (25) présente sur le côté tourné vers la carte de circuit imprimé (10) des enfoncements (28a à 28c) destinés à recevoir l'extrémité de l'élément thermoconducteur (24) qui dépasse de la carte de circuit imprimé (10).

19. Dispositif de chauffage électrique selon la revendication 17 ou 18, **caractérisé en ce que** les dissipateurs thermiques (25) de plusieurs éléments de refroidissement adjacents sont réalisés d'une seule pièce.

20. Dispositif de chauffage électrique selon la revendication 19, **caractérisé en ce que** les dissipateurs thermiques (25) réalisés d'une seule pièce sont reliés ensemble par l'intermédiaire de la première partie (26).
